# EUROPEAN PATENT SPECIFICATION

(11) **EP 2 437 393 B1**
(45) Date of publication and mention of the grant of the patent: **12.09.2012**
(21) Application number: 10290525.4
(22) Date of filing: 01.10.2010
(51) Int. Cl.: H03F 3/191, H03F 13/00, B82Y 10/00

(54) **Power control for an RF power amplifier with spectrally grouped nanosized switches**
Leistungsregelung für einen Hochfrequenzleistungsverstärker mit spektral angeordneten Schaltern in Nanogröße
Contrôle de puissance pour un amplificateur de puissance RF doté de commutateurs nanométriques spectralement groupés

(43) Date of publication of application: 04.04.2012
(73) Proprietor: Alcatel Lucent, 75007 Paris (FR)
(72) Inventor: Templ, Wolfgang, 74372 Sersheim (DE); Wiegner, Dirk, 71409 Schwaikheim (DE)
(74) Representative: Wetzel, Emmanuelle

(56) References cited:
- GB-A- 1 481 591
- US-A- 3 413 573
- US-A- 3 739 290
- JEAN-PIERRE RASKIN ET AL: "A Novel Parametric-Effect MEMS Amplifier", JOURNAL OF MICROELECTROMECHANICAL SYSTEMS, IEEE SERVICE CENTER, PISCATAWAY, NJ, US, vol. 9, no. 4, 1 December 2000 (2000-12-01), XP011034596, ISSN: 1057-7157
- GIANLUCA PIAZZA ET AL: "AlN Contour-Mode Vibrating RF MEMS for Next Generation Wireless Communications", SOLID-STATE DEVICE RESEARCH CONFERENCE, 2006. ESSDERC 2006. PROCEEDING OF THE 36TH EUROPEAN, IEEE, PI, 1 September 2006 (2006-09-01), pages 61-64, XP031046993, ISBN: 978-1-4244-0301-1
- T-C NGUYEN C ED - KINNICK R R ET AL: "6I-4 Integrated Micromechanical Circuits Fueled By Vibrating RF MEMS Technology (Invited)", ULTRASONICS SYMPOSIUM, 2006. IEEE, IEEE, PI, 1 October 2006 (2006-10-01), pages 957-966, XP031076428, DOI: DOI:10.1109/ULTSYM.2006.224 ISBN: 978-1-4244-0201-4
- REICHENBACH R B ET AL: "A MEMS RF phase and frequency modulator", SOLID-STATE SENSORS, ACTUATORS AND MICROSYSTEMS, 2005. DIGEST OF TECHN ICAL PAPERS. TRANSDUCERS '05. THE 13TH INTERNATIONAL CONFERENCE ON SEOUL, KOREA JUNE 5-9, 2005, PISCATAWAY, NJ, USA,IEEE, vol. 1, 5 June 2005 (2005-06-05), pages 1059-1062, XP010828102, DOI: DOI:10.1109/SENSOR.2005.1496638 ISBN: 978-0-7803-8994-6

## Description

### Background of the invention

The invention relates to a method for providing an amplified RF signal, with the steps of
- analysing the spectral components, namely the amplitudes and the phases at different frequencies, of a signal to be amplified,
- applying a supply voltage to coupling elements of a coupling array,
   wherein the coupling array comprises a plurality of nano-sized coupling elements, and wherein the coupling elements are grouped into a number N of sub-arrays, with each sub-array exhibiting
   - a specific resonance frequency corresponding to a frequency component of the signal to be amplified and
   - a specific attenuation of a mechanical self oscillation of its coupling elements,
- stimulating mechanical self-oscillations of the coupling elements of the sub-arrays in dependence of the spectral components of the signal to be amplified.

Such a method is known from post-published European patent application 09 290 788.0.

Wireless communication systems of the 3rd generation ("3G") and later use modulation formats which yield RF (radio frequency) output signals featuring high peak to average ratios. The amplification of such signals imposes high requirements on power efficiency and linearity to the transmitter line up, especially for the final stage of the RF power amplifier, where by far the largest share of energy is dissipated.

European patent application 09 290 788.0 discloses an amplification method wherein an amplified signal is constructed by stimulating coupling elements such as overlapping reeds at their resonance frequencies in dependence of the spectral components of a signal to be amplified. Thus an inherent up-conversion is achieved, allowing a good efficiency and good linearity.

In order to keep operational costs of an RF power amplifier low, it is often required to adapt an amplification gain to external circumstances. For instance, mobile phone signals have be transmitted with high power during times of high speech traffic, whereas during times of low speech traffic a low power is sufficient and preferred.

If a large dynamic is required at an RF signal amplification according to European patent application 09 290 788.0, there are still some spectral distortions remaining in the amplified signal resulting from non-linear gain characteristics; transmit power control and stabilization are difficult then.

### Object of the invention

It is the object of the invention to provide a method for amplifying a signal with reduced spectral distortions and with a better transmit power control over a wide range of amplification gains.

### Short description of the invention

This object is achieved, in accordance with the invention, by a method as introduced in the beginning, characterized in that the amplification gain is at least partially regulated by switching the supply voltage between different dc voltage levels.

By switching the supply voltage, which may be done for all coupling elements in common, for individual sub-arrays of coupling elements, or even individual coupling elements, the respective amplification gain may be adjusted in a simple way.

When constructing an amplified RF signal, the amplitudes of the stimulated mechanical self-oscillations of the coupling elements grouped in the sub-arrays may be altered in order to change the amplification gain. However, the correlation between a stimulation pulse and a mechanical reaction of a coupling element, and further the correlation between said mechanical reaction of the coupling element and an observed amplification gain are complex and typically difficult to predict for very strong stimulation pulses (or very strong amplification gains, respectively). Only for a moderate stimulation pulse interval said correlations are simple (such as basically linear) and thus the amplification gain is simple to control.

By switching the supply voltage, the stimulation of mechanical self oscillations can be handled in said moderate stimulation pulse interval, even if extreme amplification gains are desired. In particular, if rather high amplification gains are desired, a correspondingly high dc voltage level may be chosen, and at the same time the amplitude of the stimulated mechanical self-oscillation can be chosen moderately. Since only the moderate stimulation pulse interval is required, the (re-)construction of the amplified RF signal can be highly exact, and the introduction of signal distortions can be avoided. More specifically, the dependency between the amplification gain and the supply voltage is typically highly linear, in accordance with the invention.

So by means of the invention, a very low level of signal distortions and highly linear gain characteristics can be achieved. The transmit power control can be improved, in particular for adapting the transmit power to a currently present load. Note that along with the amplification gain, a transmission power is regulated when the method is used at an RF signal transmitter.

Note that the signal to be amplified is of ac type and typically provided on baseband level, and the amplified RF signal is up-mixed by adequately choosing the resonance frequencies around an RF center frequency (In other words, then all rfᵢ equal fᵢ + const, with const being the center frequency lowered by half of the resolved frequency width of the signal to be amplified). Thus the method can inherently provide a frequency up-conversion. However, the input signal to be amplified may also be an RF signal, and the amplification may be done without an up-conversion.

It should be noted that the control of the mechanical stimulations of the coupling elements should take into account the current supply voltage at those coupling elements, either by a priori adapting the stimulation pulses, and/or by means of a feedback loop.

Note that in accordance with the invention, one may establish individual supply voltages and thus dc voltage levels for each coupling element independent of the dc voltage levels of other coupling elements. However, typically, and also in accordance with the invention, all coupling elements of a sub-array are provided with the same supply voltage, with each sub-array or groups of sub-arrays having an individual supply voltage. It is also possible to apply the same supply voltage to all coupling elements.

### Preferred variants of the invention

In a preferred variant of the inventive method, to all coupling elements, the same supply voltage is applied. In other words, the supply voltage for all coupling elements (and thus also all sub-arrays) are switched in common. This is particularly simple. In this way, a change in the desired overall amplification gain can easily be established, without a need for extreme stimulation pulses. This variant is particularly simple to establish.

In a highly preferred variant, for regulating the amplification gain of frequency components corresponding to individual sub-arrays or groups of sub-arrays, supply voltages for individual sub-arrays or groups of sub-arrays are switched separately. Thus different dc voltage levels may be applied to different sub-arrays or groups of sub-arrays (or their coupling elements, respectively). By this means, different required amplification gains for different spectral components (or groups of spectral components) of the RF signal can be taken into account, such that for each spectral component (or group of spectral components), the mechanical stimulation of the corresponding sub-array (or group of sub-arrays) can be performed at an optimal (moderate) stimulation pulse interval. This variant may be of use for a linearization of the amplification characteristics of individual sub-arrays. Note that the current distribution of supply voltages must be taken into account at the stimulation of the sub-arrays or their coupling elements, respectively. For a group of commonly switched sub-arrays, the resonance frequencies of the sub-arrays of the group typically belong to neighbouring frequency components.

In a particularly preferred variant, the supply voltage is switched
- between at least 2, preferably at least 4 non-zero dc voltage levels, and
- between at maximum 10, preferably at maximum 5 non-zero dc voltage levels. By using a higher number of dc voltage levels, a wider range of amplification gain can be covered at high accuracy. For typical applications, about 4 or 5 dc voltage levels offer satisfying accuracy at a reasonable construction effort. It should be noted that additionally, it is possible to establish a zero voltage level, in particular to disable specific sub-arrays.

A preferred variant provides that the supply voltage is switched with a frequency of 1 kHz or less often, in particular of 1 Hz or less often. Note that time intervals between switching the supply voltage may be but need not be constant. In case that all coupling elements are switched in common, the supply voltage is typically switched only on the order of once every minute or less often. If there are only few dc voltage levels (such as only two non-zero levels), switching might be done just a few times (such as 5-10 times) or even just twice per day, such as to switch between a day time and a night time operation mode. Low frequency switching of the supply voltage is in particular useful to adapt to varying mobile telephony traffic in the course of a day; in times of high traffic, the amplification gain is increased by applying a higher dc voltage level, and in times of low traffic, the amplification gain is reduced by applying a lower dc voltage level. Note that said preferred switching frequencies do not only apply when all coupling elements are switched in common, but also when individual coupling elements or sub-arrays or groups of sub-arrays are switched separately. When switching the supply voltage for linearization purposes, higher switching frequencies than 1 kHz may be applied, though; typical switching frequencies are then in the order of the frequency (i.e. its maximum component) of the baseband signal.

In an advantageous variant of the inventive method, the amplification gain is further regulated by adjusting the fraction of coupling elements of each sub-array which is stimulated. This allows a highly accurate control of the amplification gain, since the fraction is directly proportional to the amplification gain.

In a further development of this variant, within each sub-array, there are groups of several coupling elements each whose mechanical stimulation is commonly controlled. This simplifies the control of the coupling elements. Note that despite of a common control, each coupling element within a group may have its own stimulation means. Typically, a group of coupling elements comprises from 1/50 to 1/10 of all coupling elements of the sub-array.

Preferred is a further development wherein at all sub-arrays, the same fraction of coupling elements is stimulated. This is particularly simple, and allows to adapt the overall amplification gain in a highly accurate fashion.

In an advantageous further development, for regulating the amplification gain of frequency components corresponding to individual sub-arrays or groups of sub-arrays, the fractions of coupling elements of individual sub-arrays or groups of sub-arrays are adjusted separately. Thus different fractions may be applied to different sub-arrays or groups of sub-arrays. By this means, different amplification gains for different sub-arrays or corresponding frequency components of the RF signal can be used, at high accuracy. This variant may be used for a linearization of the amplification characteristics of the sub-arrays. Note that the current distribution of fractions must be taken into account at the stimulation of the sub-arrays or their coupling elements, respectively. For a group of commonly adjusted sub-arrays, the resonance frequencies of the sub-arrays of the group typically belong to neighbouring frequency components. Particularly preferred is a further development wherein the amplification gain is coarsely regulated by switching the supply voltage, and finely regulated by adjusting the fraction of coupling elements of each sub-array which is stimulated. By this means, a particularly good control of the amplification gain is achieved. Said coarse and fine regulation is typically applied separately to the amplification gain of frequency components corresponding to individual sub-arrays or groups of sub-arrays.

A preferred variant of the inventive method provides
that the spectral components of the signal to be amplified and the spectral components of the amplified RF signal are compared,
that the amplification gain of frequency components corresponding to individual sub-arrays or groups of sub-arrays are separately controlled taking into account information provided by a feedback path,
and that taking into account the information provided by the feedback path, the supply voltages for individual sub-arrays or groups of sub-arrays are switched separately and/or the fractions of coupling elements of individual sub-arrays or groups of sub-arrays are adjusted separately. By using the feedback path (feedback loop), it is possible to achieve a particularly good control over the actual amplification gain in the amplified RF signal, in particular for an adaptive linearization of amplification characteristics of individual sub-arrays. The comparison of spectral components is typically done on baseband level. Note that the amplification gain is also controlled by the pulse form (in particular the amplitude) of the stimulation pulses which stimulate the mechanical self oscillations, which is typically integrated into the feed-back loop.

Also within the scope of the present invention is a radio frequency (=RF) power amplifier, comprising
- a coupling array comprising a plurality of nano-sized coupling elements, wherein the coupling elements are grouped into a number N of sub-arrays, with each sub-array exhibiting
   - a specific resonance frequency and
   - a specific attenuation
   of a mechanical self-oscillation of its coupling elements,
   wherein for the coupling elements of each sub array, there is a stimulating means for stimulating a mechanical self-oscillation,
- and a signal processing unit for controlling the stimulating means with stimulating pulses having a pulse form and timing calculated by the signal processing unit based on an evaluation of the spectral components of a signal to be amplified, namely the amplitudes and phases at the frequencies corresponding to said specific resonance frequencies, characterized by a voltage source device to which the coupling elements are connected, with the voltage source device being capable of providing different dc voltage levels.

By means of the different dc voltage levels, the amplification gain can be varied. The mechanical stimulation may be operated at its optimum signal pulse interval. Signal distortions can be kept to a minimum, and the amplification can be controlled very accurately. The RF power amplifier is preferably designed to perform a method as described in one of the preceding claims. By means of the inventive RF power amplifier, an inherent frequency up-conversion of the signal to be amplified (which is typically at baseband level) may be performed. The inventive RF power amplifier is typically part of a transmitter arrangement, and connected to an antenna device for this purpose. Note that N is typically 100 or more, preferably 1000 or more, and that the number of coupling elements per sub-array is typically 100 or more, preferably 1000 or more. The dimensions of the coupling elements are typically below 1000 nm, preferably 500 nm or less each, most preferably 300 nm or less each.

In an advantageous embodiment of the inventive RF power amplifier, the coupling elements are all connected in parallel at one port of the voltage source device, and the voltage source device is capable of switching the port between different dc voltage levels. In other words, all coupling elements are supplied with the same supply voltage and are switched in common. This is a simple way to control the overall amplification gain at high accuracy; in particular there is no need to take into account diverging dc levels.

An alternative, preferred embodiment of the inventive RF power amplifier is characterized in
that the voltage source device comprises several ports, each providing a different dc voltage level,
that there is a switching network for establishing and switching connections between the ports and individual sub-arrays or groups of sub-arrays, such that any one individual sub-array or group of sub-arrays may be connected to any one port,
and that the signal processing unit or a base band control unit is connected to the switching network for controlling said connections.

By this means, different amplification gains for different sub-arrays or corresponding frequency components of the RF signal can be used, at high accuracy. For the coupling elements of one sub-array, the supply voltage is the same: Preferably, any one sub-array is only connected to one port at a time. Note that alternatively, the switching network may be more complex, such that the switching network may establish and switch connections between ports and individual coupling elements, such that any one coupling element may be connected to any one port. Note that it is possible to let a baseband control unit control the switching network, but then the baseband control unit should be connected to the signal processing unit so the signal processing unit may be informed about the current dc voltage levels for each sub-array.

In another advantageous embodiment, for each sub-array, there is a plurality of stimulation means, with each of said stimulation means arranged for stimulating mechanical self-oscillations of an individual coupling element or a group of coupling elements of the sub-array. By using a plurality of stimulating means, fractions of the coupling elements of a sub-array may be chosen for stimulation, while remaining coupling elements are not chosen for stimulation. This allows to control the amplification gain at high linearity.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing and detailed description of the invention

The invention is shown in the drawing.
- Fig. 1: shows schematically an embodiment of an inventive RF power amplifier, suitable for performing an inventive method for providing an amplified RF signal, wherein all sub-arrays are connected to one port of a voltage supply device;
- Fig. 2: shows schematically another embodiment of an inventive RF power amplifier, suitable for performing an inventive method for providing an amplified RF signal, wherein the sub-arrays are connected to one of a plurality of ports of a voltage supply device each.

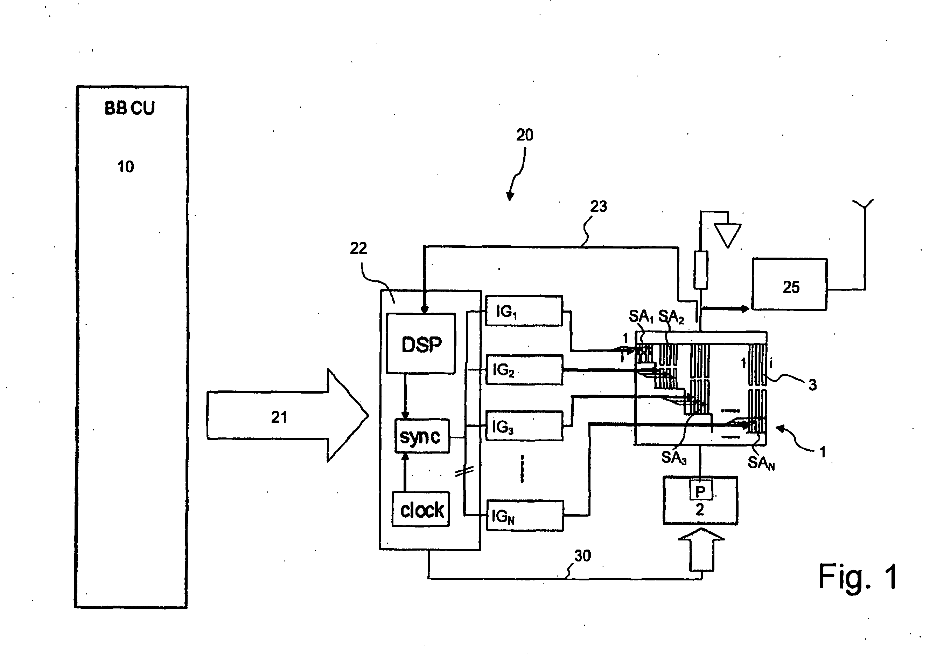

Fig. 1 shows an exemplary embodiment of an inventive RF power amplifier 20.

First, the basic operation of the RF power amplifier 20 is explained. Note that the basic operation principle (including the function of most components) is also described in European patent application 09 290 788.0, the content of which is herewith incorporated by reference.

Basically, an amplified RF signal is generated by supplying a supply voltage of dc type, originating from a port P of a voltage supply device 2, to a coupling array 1. Said coupling array 1 comprises a number N of sub-arrays SA₁-SA_{N}, each comprising (here) a number i of coupling elements 3 (note that for simplicity, only three coupling elements per sub-array are shown, but in practice, there are typically a hundred or more coupling elements per sub-array). The coupling elements 3 of each sub-array SA₁...SA_{N} exhibit a specific resonance frequency (rf₁...rf_{N}) and a specific attenuation. In the example shown, each coupling element 3 consists of a pair of opposing reeds, the distance of which varies when the coupling element 3 is subject to a mechanical self oscillation (note that other coupling elements, e.g. based on vibrating membranes or torsion oscillations of bar elements, are also possible, compare European patent application 09 290 788.0). When the coupling elements 3 of a specific sub-array SA₁...SA_{N} oscillate (typically in phase), the coupling of the two sides of the coupling array 1 (in Fig. 1 with a top side and a bottom side) changes with the oscillation frequency (i.e. the specific resonance frequency), and an ac type current through the coupling array 1 with a spectral component (frequency component) corresponding to the specific frequency results. The mechanical self oscillations of the coupling elements 3 are induced by stimulating means, such as piezoelectric coatings on the reeds (not shown in detail).

The RF power amplifier 20 comprises a signal processing unit 22, which receives information 21 about the spectral components (i.e. frequencies f₁ ... f_{N}, amplitudes C₁ ... C_{N} and phases Φ₁ ... Φ_{N}) of a signal (input signal) to be amplified from a base band control unit 10 (Note that in accordance with the invention, it is also possible to have an analyzing unit integrated in a signal processing unit wherein the analyzing unit identifies the spectral components of an input signal to be amplified, which is directly fed to the signal processing unit).

With this spectral component information 21, the signal processing unit 22 calculates the pulse form and timing for stimulating pulses. In the example shown, this information is sent to stimulating impulse generators IG₁...IG_{N,} with one stimulating impulse generator IG₁...IG_{N} for each sub-array SA₁...SA_{N} of the coupling array 1. The stimulating impulse generators IG_{N} create stimulating pulses for their respective sub-array SAₙ each, based on the pulse form and timing information from the signal processing unit 22., i.e. the stimulating pulses are used to drive the stimulating means of the coupling elements 3.

The amplitude of the stimulating pulse determines the power of the spectral component and the timing determines its phasing. The calculation of the pulse form and timing is (here) based on the spectral input information on baseband level, a fed back sample (see feedback path 23) of the RF output signal, and a reference clock 24. The resonance frequencies rf₁...rf_{N} of the coupling elements within the sub-arrays SA₁...SA_{N} are fixed and correspond to the frequencies f₁...f_{N} of the analyzed spectral components of the input signal. The amplified RF output signal is fed into an antenna network 25, which transmits the amplified RF output signal into the surroundings.

As an example, an inventive RF power amplifier 20 may apply a frequency resolution in equal steps of between 1 kHz and 50 kHz, with a typical width of a resolved frequency interval of between 1 MHz and 50 MHz. The center frequency of the amplified RF signal is typically between 500 MHz and 10 GHz (note that the input signal is typically at baseband level). For example, with a frequency resolution of 50 kHz and a width of 50 MHz, the coupling array 1 comprises about 1000 sub-arrays, i.e. N=1000; the baseband level input signal has 1000 components from 0 to 50 MHz, and the amplified RF signal has 1000 components from 975 MHz to 1025 MHz, with a center frequency of 1000 MHz. Note that in case of fragmented bands, widths of 100 MHz or even more may be covered (albeit often with unused gaps in between).

In order to control the amplification gain of the RF power amplifier 20, the dc voltage level of the supply voltage device 2 at port P (to which all coupling elements 3 of all sub-arrays SA₁...SA_{N} are connected in this embodiment) may be changed. Preferably, the supply voltage device 2 is designed as a multistage buck converter, which may be switched between dc voltage levels of e.g. 50 V, 40 V, 30 V, 20 V and 10V.

By choosing the dc voltage level of the supply voltage device 2 or its port P, respectively, the overall amplification gain of the amplified RF output signal can be coarsely set. The dc voltage level is directly proportional to the amplification gain. So the coupling array 1 may operate within its optimum signal pulse interval, i.e. with a limited dynamic range, while the overall dynamic range of the RF power amplifier 20 may be expanded (or narrowed) by increasing (or decreasing) the dc voltage level.

In the embodiment shown, the supply voltage device 2 or the dc voltage level, respectively, can be controlled by the signal processing unit 22, compare control line 30. When changing the amplification gain, instead of or in addition to changing the mechanical stimulation at all sub-arrays SA₁...SA_{N}, the signal processing unit 22 may order a change of the dc voltage level, in particular in case the change of the mechanical stimulation would lead out of an optimum (moderate) stimulation pulse interval outside of which non-linear correlations of stimulation pulse amplitude and amplification gain occur.

Note that in general, the signal processing unit 22 should know, in addition to the desired amplification level, about the current dc voltage level in order to have a good a priori idea of the resulting amplification gain, even if the signal processing unit cannot control the supply voltage device 2 (this is particularly true if no feedback path has been established). More specifically, the supply voltage device 2 might be controlled by the base band control unit 10; this is often the case when the amplification gain has to be adapted for external circumstances, such as the time of day.

An additional power control can be established by varying the fraction of coupling elements 3 of a sub-array SA₁...SA_{N} which are mechanically stimulated; the number (or fraction, respectively) of excited coupling elements 3 is related (typically linearly in good approximation) to the amplification gain.

For this purpose, the stimulating impulse generators IG₁... IG_{N} can chose the number of coupling elements 3 to be stimulated in their corresponding sub-array SA₁...SA_{N}. In the example shown, the each coupling element 1...i of a sub-array is individually connected to the stimulating impulse generator IG₁ ... IG_{N} of its sub-array SA₁...SA_{N}. The stimulating impulse generator IG₁ ... IG_{N} sends stimulation signals only to those coupling elements 3 intended for mechanical oscillation ("stimulated fraction"); the signal lines 44 are of multiconductor type for this purpose, with a branching at the ends to each coupling element 3. Note that for simplification of the design, coupling elements 3 of a group within a sub-array SA₁...SA_{N} may also be controlled in common.

It should be noted that the fraction of coupling elements 3 stimulated can be chosen individually for each sub-array SA₁...SA_{N}, which allows to take into account different amplification needs of different spectral components; it is also possible to equalize diverging amplification characteristics of different sub-arrays by a proper choice of fractions ("linearization"). Preferably, the signal processing unit indicates to the stimulation impulse generators the fraction of coupling elements to be excited, typically individually for each sub-array.

Preferably, and in accordance with the invention, for an output power control in medium and larger steps, the supply voltage control is used. For output power control in small steps or for power adaption (e.g. in a feedback loop or for linearization purposes), control of the fraction of coupling elements 3 is used.

In the illustrated example, the feedback path 23 feeds information about the amplified RF signal to the signal processing unit 22. However, it is also possible to feed the information about the amplified RF signal into the base band control unit 10. In both cases, in order to be able to compare the amplified RF signal with the input signal to be amplified (or the corresponding spectral component information 21), the amplified RF signal may be down-converted and compared to the spectral component information 21, or the spectral component information may be up-converted and compared to the amplified RF signal.

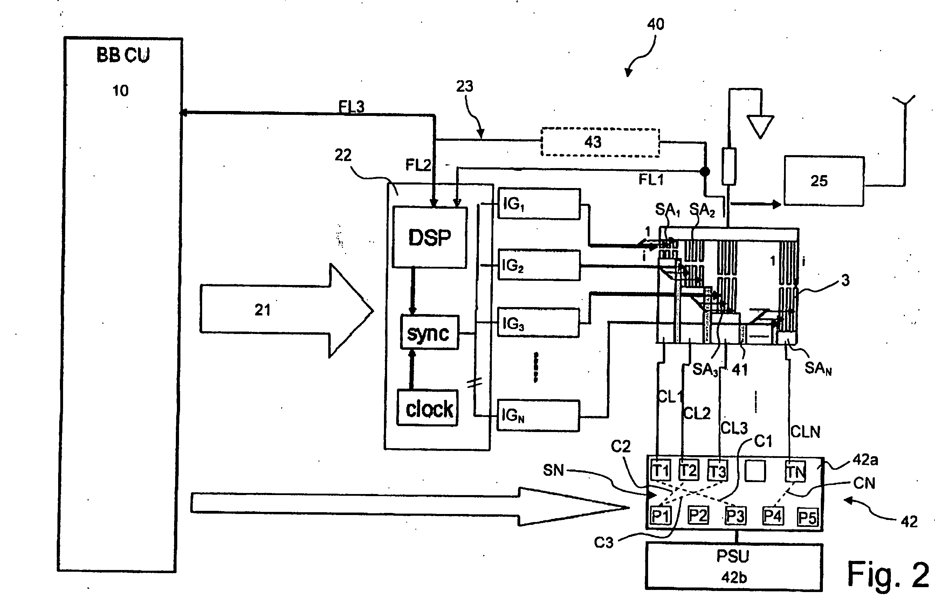

Fig. 2 shows a further embodiment of an inventive RF power amplifier 40. Only the differences with respect to the embodiment of Fig. 1 are explained in detail.

In the coupling array 1, the sub-arrays SA₁...SA_{N} are electrically isolated from each other on the side connected to the voltage supply device 42 (in Fig. 2 the bottom side), compare isolation 41.

The supply voltage device 42 is designed as with a multichannel output power controller 42a, with (here) five ports P1-P5, providing different dc voltage levels of here fixed 10V, 20; 30V, 40V and 50V, and a power supply unit 42b connected to the multichannel output power controller 42a. Further, the multichannel output power controller 42a comprises a number N of terminals T1...TN, which are connected to the N sub-arrays SA₁...SA_{N} by connection lines CL1...CLN. By means of the multichannel output power controller 42a, each terminal T1...TN is connected to one of said ports P1...P5 by means of connections C1...CN. Said connections C1...CN may be altered, such that each terminal T1...TN may be connected to each one of the ports P1...P5. In other words, the multichannel output power controller 42a provides a switching network SN for connecting each sub-array SA₁-SA_{N} to one of said ports P1-P5. In the example shown, T1 (or SA₁) is connected to P3 via C1, further T2 (or SA₂) and T3 (or SA₃) are connected to P1 via C2 and C3, and TN (or SA_{N}) is connected to P4 via CN.

By this means, it is possible to coarsely choose the amplification gain for each sub-array SA₁-SA_{N} individually, simply by connecting the sub-array SA₁-SA_{N} to an appropriate port P1...P5 or dc voltage level, respectively. Thus different required amplification gains for different spectral components of the signal to be amplified can be taken into account (e.g. to establish a linearization, if necessary).

The supply voltage device 42, or more exactly the switching network SN therein, are here controlled by the base band control unit 10. From the spectral component information 21 (which is also provided by the base band control unit 10 to the signal processing unit 22), the base band control unit 10 individually determines the required amplification gain for each frequency component f₁...f_{N} or sub-array SA₁...SA_{N}. respectively, and orders an appropriate dc voltage level for each sub-array SA₁...SA_{N} at the voltage supply device 42. For high amplification gains, a high dc voltage level is chosen, whereas for low amplifications gains, a low dc voltage level is chosen. Note that it is also possible to let the signal processing unit 22 order the dc voltage levels.

Again, the amplification gain can further be controlled via the fraction of coupling elements 3 stimulated in each sub-array SA₁...SA_{N}.

Note that the dc voltage levels as well as the fractions are chosen taking into account linearization/equailzation needs and required transmission power.

When using the supply voltage for coarse and medium amplification gain control, and the fraction of stimulated coupling elements 3 of a sub-array SA₁...SA_{N} for fine amplification gain control, the mechanical stimulation can be done with a fixed amplitude, avoiding any non-linear characteristic caused by complex correlations between the mechanical stimulation and the amplification gain; note that the switching of fractions of stimulated coupling elements within the sub-arrays must be very quick then. Most often, a minimum of amplification gain control will remain at the mechanical stimulation (i.e. at the stimulation pulse form, including amplitude, respectively).

Fig. 2 illustrates possible feedback paths 23 for improving the quality (or congruence with respect to the signal to be amplified) of the amplified RF signal. The amplified RF signal can be fed back directly into the signal processing unit 22, see FL1. Then the signal processing unit 22 should up-convert a signal for comparison, from the spectral component information 21. Alternatively, the amplified RF signal can be down-converted (to baseband level) in a down conversion unit 43, and fed into the signal processing unit 22 for comparison (after digitalization) with the spectral component information 21 on baseband level. It is also possible to feed the down-converted amplified RF signal into the base band control unit 10, see FL3, and to do the comparison on baseband level there. The spectral component information 21 delivered may then take into account deviances between the amplified RF signal and the signal to be amplified.

In summary, the invention proposes a method for controlling an RF power amplifier with coupling elements grouped into sub-arrays responsible for spectral components of an amplified RF signal to be generated. The amplification gain is adjusted via the supply voltage level at the coupling array. This means that the output power is chosen by means of the voltage (Note that with regular amplifiers, in contrast, the output power is chosen via the input power, and the voltage is adapted to the power). In the preferred embodiment, a selective power input to each sub-array is established, with the sub-arrays being mutually electrically isolated, and with a different supply voltage being provided to each sub-array; this is particularly useful for establishing a linearization of amplification gains at the different sub-arrays. If only the amplification gain (or a transmission power, respectively) is to be varied as a whole, all sub-arrays may be provided with the same supply voltage (so mutual insulation is not required), which may be switched between different levels. By means of controlling the number of excited coupling elements (typically reeds) per sub-array (or frequency component), a further fine adjustment of equalization may be achieved. The stimulation of the coupling elements of the sub-arrays, the supply voltage distribution and, if applicable, the distribution of fractions of stimulated coupling elements within the sub-arrays is coordinated in accordance to meet the overall linearity and power requirements.

## Claims

1. A method for providing an amplified RF signal, with the steps of
- analysing the spectral components, namely the amplitudes and the phases at different frequencies, of a signal to be amplified,
- applying a supply voltage to coupling elements (3) of a coupling array (1),
wherein the coupling array (1) comprises a plurality of nano-sized coupling elements (3), and wherein the coupling elements (3) are grouped into a number N of sub-arrays (SA₁...SA_{N}), with each sub-array (SA₁... SA_{N}) exhibiting
• a specific resonance frequency corresponding to a frequency component of the signal to be amplified and
• a specific attenuation of a mechanical self oscillation of its coupling elements (3),
- stimulating mechanical self-oscillations of the coupling elements (3) of the sub-arrays (SA₁...SA_{N}) in dependence of the spectral components of the signal to be amplified,
**characterized in**
**that** the amplification gain is at least partially regulated by switching the supply voltage between different dc voltage levels.

2. A method according to claim 1, **characterized in that** to all coupling elements (3), the same supply voltage is applied.

3. A method according to claim 1, **characterized in that** for regulating the amplification gain of frequency components corresponding to individual sub-arrays (SA₁...SA_{N}) or groups of sub-arrays (SA₁...SA_{N}), supply voltages for individual sub-arrays (SA₁...SA_{N}) or groups of sub-arrays (SA₁...SA_{N}) are switched separately.

4. A method according to claim 1, **characterized in that** the supply voltage is switched
- between at least 2, preferably at least 4 non-zero dc voltage levels, and
- between at maximum 10, preferably at maximum 5 non-zero dc voltage levels.

5. A method according to claim 1, **characterized in that** the supply voltage is switched with a frequency of 1 kHz or less often, in particular of 1 Hz or less often.

6. Method according to claim 1, **characterized in that** the amplification gain is further regulated by adjusting the fraction of coupling elements (3) of each sub-array (SA₁.... SA_{N}) which is stimulated.

7. Method according to claim 6, **characterized in that** within each sub-array (SA₁...SA_{N}), there are groups of several coupling elements (3) each whose mechanical stimulation is commonly controlled.

8. Method according to claim 6, **characterized in that** at all sub-arrays (SA₁...SA_{N}), the same fraction of coupling elements (3) is stimulated.

9. Method according to claim 6, **characterized in that** for regulating the amplification gain of frequency components corresponding to individual sub-arrays (SA₁....SA_{N}) or groups of sub-arrays (SA₁...SA_{N}), the fractions of coupling elements (3) of individual sub-arrays (SA₁...SA_{N}) or groups of sub-arrays (SA₁...SA_{N}) are adjusted separately.

10. Method according to claim 6, **characterized in that** the amplification gain is coarsely regulated by switching the supply voltage, and finely regulated by adjusting the fraction of coupling elements (3) of each sub-array (SA₁...SA_{N}) which is stimulated.

11. Method according to claim 1, **characterized in that** the spectral components of the signal to be amplified and the spectral components of the amplified RF signal are compared, that the amplification gain of frequency components corresponding to individual sub-arrays (SA₁...SA_{N}) or groups of sub-arrays (SA₁...SA_{N}) are separately controlled taking into account information provided by a feedback path (23),
and that taking into account the information provided by the feedback path (23), the supply voltages for individual sub-arrays (SA₁...SA_{N}) or groups of sub-arrays (SA₁... SA_{N}) are switched separately and/or the fractions of coupling elements (3) of individual sub-arrays (SA₁...SA_{N}) or groups of sub-arrays (SA₁...SA_{N}) are adjusted separately.

12. Radio frequency (RF) power amplifier (20; 40), comprising
- a coupling array (1) comprising a plurality of nano-sized coupling elements (3),
wherein the coupling elements (3) are grouped into a number N of sub-arrays (SA₁...SA_{N}), with each sub-array (SA₁...SA_{N}) exhibiting
• a specific resonance frequency and
• a specific attenuation
of a mechanical self-oscillation of its coupling elements (3), wherein for the coupling elements (3) of each sub array (SA₁...SA_{N}), there is a stimulating means for stimulating a mechanical self-oscillation,
- and a signal processing unit (22) for controlling the stimulating means with stimulating pulses having a pulse form and timing calculated by the signal processing unit (22) based on an evaluation of the spectral components of a signal to be amplified, namely the amplitudes and phases at the frequencies corresponding to said specific resonance frequencies,
**characterized by**
a voltage source device (2; 42) to which the coupling elements (3) are connected, with the voltage source device (2; 42) being capable of providing different dc voltage levels.

13. RF power amplifier (20; 40) according to claim 12, **characterized in that** the coupling elements (3) are all connected in parallel at one port (P) of the voltage source device (2; 42), and the voltage source device (2; 42) is capable of switching the port (P) between different de voltage levels.

14. RF power amplifier (20; 40) according to claim 12, **characterized in that** the voltage source device (2; 42) comprises several ports (P1...P5), each providing a different dc voltage level,
that there is a switching network (SN) for establishing and switching connections (C1...CN) between the ports (P1...P5) and individual sub-arrays (SA₁... SA_{N}) or groups of sub-arrays (SA₁... SA_{N}), such that any one individual sub-array (SA₁...SA_{N}) or group of sub-arrays (SA₁... SA_{N}) may be connected to any one port (P1...P5),
and that the signal processing unit (22) or a base band control unit (10) is connected to the switching network (SN) for controlling said connections (C1...CN).

15. RF power amplifier (20; 40) according to claim 12, **characterized in that** for each sub-array (SA₁... SA_{N}), there is a plurality of stimulation means, with each of said stimulation means arranged for stimulating mechanical self-oscillations of an individual coupling element (3) or a group of coupling elements (3) of the sub-array (SA₁...SA_{N}).

## Patentansprüche

1. Verfahren zur Bereitstellung eines verstärkten Hochfrequenzsignals, die folgenden Schritte umfassend:
- Analysieren der spektralen Komponenten, und zwar der Amplituden und der Phasen bei unterschiedlichen Frequenzen, eines zu verstärkenden Signals,
- Anlegen einer Versorgungsspannung an Kopplungselemente (3) einer Kopplungsanordnung (1),
wobei die Kopplungsanordnung (1) eine Mehrzahl von Kopplungselementen (3) in Nanogröße umfasst, und wobei die Kopplungselemente (3) in eine Anzahl N von Unteranordnungen (SA₁...SA_{N}) gruppiert sind, wobei jede Unteranordnung (SA₁...SA_{N}) aufweist:
• Eine spezifische Resonanzfrequenz, welche einer Frequenzkomponente des zu verstärkenden Signals entspricht, und
• eine spezifische Abschwächung
einer mechanischen Eigenschwingung ihrer Kopplungselemente (3),
- Stimulieren von mechanischen Eigenschwingungen der Kopplungselemente (3) der Unteranordnungen (SA₁...SA_{N}) in Abhängigkeit von den spektralen Komponenten des zu verstärkenden Signals,
**dadurch gekennzeichnet,**
**dass** die Verstärkung zumindest teilweise durch Schalten der Versorgungsspannung zwischen den verschiedenen Gleichspannungspegeln geregelt wird.

2. Verfahren nach Anspruch 1, **dadurch gekennzeichnet, dass** an alle Kopplungselemente (3) dieselbe Versorgungsspannung angelegt wird.

3. Verfahren nach Anspruch 1, **dadurch gekennzeichnet, dass** zur Regelung der Verstärkung von Frequenzkomponenten, welche einzelnen Unteranordnungen (SA₁...SA_{N}) oder Gruppen von Unteranordnungen (SA₁...SA_{N}) entsprechen, Versorgungsspannungen für einzelne Unteranordnungen (SA₁...SA_{N}) oder Gruppen von Unteranordnungen (SA₁...SA_{N}) separat geschaltet werden.

4. Verfahren nach Anspruch 1, **dadurch gekennzeichnet, dass** die Versorgungsspannung
- zwischen mindestens 2, vorzugsweise mindestens 4 Nicht-Null-Gleichspannungspegeln, und
- zwischen maximal 10, vorzugsweise maximal 5 Nicht-Null-Gleichspannungspegeln geschaltet wird.

5. Verfahren nach Anspruch 1, **dadurch gekennzeichnet, dass** die Versorgungsspannung mit einer Frequenz von 1 kHz oder weniger oft, insbesondere von 1 Hz oder weniger oft, geschaltet wird.

6. Verfahren nach Anspruch 1, **dadurch gekennzeichnet, dass** die Verstärkung weiterhin durch Anpassen des Anteils von Kopplungselementen (3) einer jeden Unteranordnung (SA₁...SA_{N}), welche stimuliert wird, geregelt wird.

7. Verfahren nach Anspruch 6, **dadurch gekennzeichnet, dass** innerhalb jeder Unteranordnung (SA₁....SA_{N}) Gruppen von mehreren Kopplungselementen (3) bestehen, deren mechanische Stimulation gemeinsam gesteuert wird.

8. Verfahren nach Anspruch 6, **dadurch gekennzeichnet, dass** in allen Unteranordnungen (SA₁...SA_{N}) derselbe Anteil von Kopplungselementen (3) stimuliert wird.

9. Verfahren nach Anspruch 6, **dadurch gekennzeichnet, dass** zur Regelung der Verstärkung von Frequenzkomponenten, welche einzelnen Unteranordnungen (SA₁...SA_{N}) oder Gruppen von Unteranordnungen (SA₁...SA_{N}) entsprechen, die Anteile von Kopplungselementen (3) einzelner Unteranordnungen (SA₁...SA_{N}) oder Gruppen von Unteranordnungen (SA₁...SA_{N}) separat angepasst werden.

10. Verfahren nach Anspruch 6, **dadurch gekennzeichnet, dass** die Verstärkung durch Schalten der Versorgungsspannung grob und durch Anpassen des Anteils von Kopplungselementen (3) einer jeden Unteranordnung (SA₁...SA_{N}), welche stimuliert wird, fein geregelt wird.

11. Verfahren nach Anspruch 1, **dadurch gekennzeichnet,**
**dass** die spektralen Komponenten des zu verstärkenden Signals und die spektralen Komponenten des verstärkten Hochfrequenzsignals verglichen werden,
**dass** die Verstärkung von Frequenzkomponenten, welche einzelnen Unteranordnungen (SA₁...SA_{N}) oder Gruppen von Unteranordnungen (SA₁...SA_{N}) entsprechen, unter Berücksichtigung von von einem Rückkopplungspfad (23) bereitgestellten Informationen separat gesteuert wird,
und **dass**, unter Berücksichtigung der von dem Rückkopplungspfad (23) bereitgestellten Informationen, die Versorgungsspannungen für einzelne Unteranordnungen (SA₁...SA_{N}) oder Gruppen von Unteranordnungen (SA₁...SA_{N}) separat geschaltet werden und/oder die Anteile von Kopplungselementen (3) von einzelnen Unteranordnungen (SA₁...SA_{N}) oder Gruppen von Unteranordnungen (SA₁...SA_{N}) separat angepasst werden.

12. Hochfrequenz- bzw. RF-Leistungsverstärker (20; 40), umfassend:
- Eine Kopplungsanordnung (1) mit einer Mehrzahl von Kopplungselementen (3) in Nanogröße,
wobei die Kopplungselemente (3) in eine Anzahl N von Unteranordnungen (SA₁....SA_{N}) gruppiert sind, wobei jede Unteranordnung (SA₁...SA_{N}) aufweist:
• Eine spezifische Resonanzfrequenz, und
• eine spezifische Abschwächung
einer mechanischen Eigenschwingung ihrer Kopplungselemente (3),
wobei für die Kopplungselemente (3) jeder Unteranordnung (SA₁...SA_{N}) ein Stimulationsmitel zum Stimulieren einer mechanischen Eigenschwingung vorhanden ist,
- und eine Signalverarbeitungseinheit (22) zum Steuern der Stimulationsmittel mit Stimulationsimpulsen, mit einer durch die Signalverarbeitungseinheit (22) auf der Basis einer Bewertung der spektralen Komponenten eines zu verstärkenden Signals, und zwar der Amplituden und Phasen bei den besagten spezifischen Resonanzfrequenzen entsprechenden Frequenzen, berechneten Impulsform und Zeitplanung,
**gekennzeichnet durch**
eine Spannungsquellvorrichtung (2; 42), an welche die Kopplungselemente (3) angeschlossen sind, wobei die Spannungsquellvorrichtung (2; 42) fähig ist, unterschiedliche Gleichspannungspegel bereitzustellen.

13. RF-Leistungsverstärker (20; 40) nach Anspruch 12, **dadurch gekennzeichnet, dass** die Kopplungselemente (3) alle parallel an einem Port (P) der Spannungsquellvorrichtung (2; 42) angeschlossen sind, und dass die Spannungsquellvorrichtung (2; 42) fähig ist, den Port (P) zwischen verschiedenen Spannungspegeln zu schalten.

14. RF-Leistungsverstärker (20; 40) nach Anspruch 12, **dadurch gekennzeichnet, dass** die Spannungsquellvorrichtung (2; 42) mehrere Ports (P1... P5) umfasst, welche jeweils einen unterschiedlichen Gleichspannungspegel bereitstellen,
dass ein Schaltnetzwerk (SN) zum Aufbauen und Schalten von Verbindungen (C1...CN) zwischen den Ports (P1...P5) und einzelnen Unteranordnungen (SA₁...SA_{N}) oder Gruppen von Unteranordnungen (SA₁...SA_{N}) vorhanden ist, so dass jede beliebige einzelne Unteranordnung (SA₁...SA_{N}) oder Gruppe von Unteranordnungen (SA₁...SA_{N}) an jeden beliebigen Port (P1....P5) angeschlossen werden kann, und dass die Signalverarbeitungseinheit (22) oder eine Basisband-Steuereinheit (10) an das Schaltnetzwerk (SN) angeschlossen ist, um die besagten Verbindungen (C1...CN) zu steuern.

15. RF-Leistungsverstärker (20; 40) gemäß Anspruch 12, **dadurch gekennzeichnet, dass** für jede Unteranordnung (SA₁...SA_{N}) eine Mehrzahl von Stimulationsmitteln vorhanden ist, wobei ein jedes der besagten Stimulationsmittel für die Stimulierung von mechanischen Eigenschwingungen eines einzelnen Kopplungselements (3) oder einer Gruppe von Kopplungselementen (3) der Unteranordnung (SA₁...SA_{N}) ausgelegt ist.

## Revendications

1. Procédé pour fournir un signal RF amplifié, avec les étapes suivantes
- analyser les composantes spectrales, à savoir les amplitudes et les phases à différentes fréquences d'un signal à amplifier,
- appliquer une tension d'alimentation à des éléments de couplage (3) d'un réseau de couplage (1),
dans lequel le réseau de couplage (1) comprend une pluralité d'éléments de couplage nanométriques (3), et dans lequel les éléments de couplage (3) sont regroupés en un nombre N de sous-réseaux (SA₁....SA_{N}), chaque sous-réseau (SA₁...SA_{N}) présentant
• une fréquence de résonance spécifique correspondant à une composante de fréquence du signal à amplifier et
• une atténuation spécifique
d'une auto-oscillation mécanique de ses éléments de couplage (3),
- stimuler des auto-oscillations mécaniques des éléments de couplage (3) des sous-réseaux (SA₁...SA_{N}) en fonction des composantes spectrales du signal à amplifier,
**caractérisé en ce que**
le gain d'amplification est au moins partiellement régulé en commutant la tension d'alimentation entre des niveaux de tension CC différents.

2. Procédé selon la revendication 1, **caractérisé en ce que** la même tension d'alimentation est appliquée à tous les éléments de couplage (3).

3. Procédé selon la revendication 1, **caractérisé en ce que** pour réguler le gain d'amplification de composantes de fréquence correspondant à des sous-réseaux individuels (SA₁...SA_{N}) ou à des groupes de sous-réseaux (SA₁...SA_{N}), des tensions d'alimentation pour des sous-réseaux individuels (SA₁...SA_{N}) ou des groupes de sous-réseaux (SA₁...SA_{N}) sont commutées séparément.

4. Procédé selon la revendication 1, **caractérisé en ce que** la tension d'alimentation est commutée
- entre au moins 2, de préférence au moins 4 niveaux de tension CC non-nuls, et
- entre au maximum 10, de préférence au maximum 5 niveaux de tension CC non-nuls.

5. Procédé selon la revendication 1, **caractérisé en ce que** la tension d'alimentation est commutée avec une fréquence de 1 kHz ou moins, en particulier de 1 Hz ou moins.

6. Procédé selon la revendication 1, **caractérisé en ce que** le gain d'amplification est en outre régulé en ajustant la fraction d'éléments de couplage (3) de chaque sous-réseau (SA₁...SA_{N}) qui est stimulée.

7. Procédé selon la revendication 6, **caractérisé en ce que** dans chaque sous-réseau (SA₁...SA_{N}), on trouve des groupes de plusieurs éléments de couplage (3), la stimulation mécanique de chaque élément de couplage étant commandée conjointement.

8. Procédé selon la revendication 6, **caractérisé en ce que** la même fraction d'éléments de couplage (3) est stimulée au niveau de l'ensemble des sous-réseaux (SA₁...SA_{N}).

9. Procédé selon la revendication 6, **caractérisé en ce que** pour réguler le gain d'amplification de composantes de fréquence correspondant à des sous-réseaux individuels (SA₁...SA_{N}) ou à des groupes de sous-réseaux (SA₁...SA_{N}), les fractions d'éléments de couplage (3) de sous-réseaux individuels (SA₁...SA_{N}) ou de groupes de sous-réseaux (SA₁...SA_{N}) sont ajustées séparément.

10. Procédé selon la revendication 6, **caractérisé en ce que** le gain d'amplification est grossièrement régulé en commutant la tension d'alimentation, et finement régulé en ajustant la fraction d'éléments de couplage (3) de chaque sous-réseau (SA₁...SA_{N}) qui est stimulée.

11. Procédé selon la revendication 1, **caractérisé en ce que**
les composantes spectrales du signal à amplifier et les composantes spectrales du signal RF amplifié sont comparées,
le gain d'amplification de composantes de fréquence correspondant à des sous-réseaux individuels (SA₁...SA_{N}) ou à des groupes de sous-réseaux (SA₁...SA_{N}) est commandé séparément en tenant compte d'informations fournies par un trajet de contre-réaction (23), et **en ce que** en tenant compte des informations fournies par le trajet de contre-réaction (23), les tensions d'alimentation pour des sous-réseaux individuels (SA₁...SA_{N}) ou des groupes de sous-réseaux (SA₁....SA_{N}) sont commutées séparément et/ou les fractions d'éléments de couplage (3) de sous-réseaux individuels (SA₁...SA_{N}) ou de groupes de sous-réseaux (SA₁...SA_{N}) sont ajustées séparément.

12. Amplificateur de puissance radiofréquence (RF) (20 ; 40), comprenant
- un réseau de couplage (1) comprenant une pluralité d'éléments de couplage nanométriques (3),
dans lequel les éléments de couplage (3) sont regroupés en un nombre N de sous-réseaux (SA₁...SA_{N}), chaque sous-réseau (SA₁...SA_{N}) présentant
• une fréquence de résonance spécifique et
• une atténuation spécifique
d'une auto-oscillation mécanique de ses éléments de couplage (3),
dans lequel pour les éléments de couplage (3) de chaque sous-réseau (SA₁...SA_{N}), il existe un moyen de stimulation destiné à stimuler une auto-oscillation mécanique,
- et une unité de traitement de signaux (22) pour commander le moyen de stimulation avec des impulsions de stimulation présentant une forme d'impulsion et une synchronisation calculées par l'unité de traitement de signaux (22) sur la base d'une évaluation des composantes spectrales d'un signal à amplifier, à savoir les amplitudes et les phases aux fréquences correspondant auxdites fréquences de résonance spécifiques,
**caractérisé par**
un dispositif source de tension (2 ; 42) auquel les éléments de couplage (3) sont connectés, le dispositif source de tension (2 ; 42) étant capable de fournir des niveaux de tension CC différents.

13. Amplificateur de puissance RF (20 ; 40) selon la revendication 12, **caractérisé en ce que** les éléments de couplage (3) sont tous connectés en parallèle à un port (P) du dispositif source de tension (2 ; 42), le dispositif source de tension (2 ; 42) pouvant commuter le port (P) entre des niveaux de tension CC différents.

14. Amplificateur de puissance RF (20 ; 40) selon la revendication 12, **caractérisé en ce que** le dispositif source de tension (2 ; 42) comprend plusieurs ports (P1...P5), chacun fournissant un niveau de tension CC différent,
**en ce qu'**il existe un réseau de commutation (SN) pour établir et commuter des connexions (C1...CN) entre les ports (P1...P5) et des sous-réseaux individuels (SA₁...SA_{N}) ou des groupes de sous-réseaux (SA₁...SA_{N}), de sorte que n'importe quel sous-réseau individuel (SA₁...SA_{N}) ou groupe de sous-réseaux (SA₁...SA_{N}) puisse être connecté à n'importe quel port (P1...P5), et **en ce que** l'unité de traitement de signaux (22) ou une unité de commande de bande de base (10) est connectée au réseau de commutation (SN) pour commander lesdites connexions (C1...CN).

15. Amplificateur de puissance RF (20 ; 40) selon la revendication 12, **caractérisé en ce que** pour chaque sous-réseau (SA₁...SA_{N}), il existe une pluralité de moyens de stimulation, chacun desdits moyens de stimulation étant conçu pour stimuler des auto-oscillations mécaniques d'un élément de couplage individuel (3) ou d'un groupe d'éléments de couplage (3) du sous-réseau (SA₁...SA_{N}).*
